Europäisches Patentamt

European Patent Office

Office européen des brevets

(11) Veröffentlichungsnummer: **0 492 217 A2**

# EUROPÄISCHE PATENTANMELDUNG

(21) Anmeldenummer: **91120969.0**

(22) Anmeldetag: **06.12.91**

(51) Int. Cl.5: **G01R 31/302**, G01R 31/305

(30) Priorität: **20.12.90 DE 4041027**

(43) Veröffentlichungstag der Anmeldung:
**01.07.92 Patentblatt 92/27**

(84) Benannte Vertragsstaaten:
**AT BE CH DE FR GB IT LI NL**

(71) Anmelder: **Siemens Nixdorf**
**Informationssysteme Aktiengesellschaft**
**Fürstenallee 7**
**W-4790 Paderborn(DE)**

(72) Erfinder: **Gelzer, Friedbert**
**Gerstenstrasse 6**
**W-8900 Augsburg(DE)**
Erfinder: **Württenberger, Volker, Dipl.-Ing.**
**Guttenbrunnstrasse 12**
**W-8900 Augsburg(DE)**

(74) Vertreter: **Fuchs, Franz-Josef, Dr.-Ing. et al**
**Postfach 22 13 17**
**W-8000 München 22(DE)**

(54) **Prüfeinrichtung für Bauelemente.**

(57) Die Erfindung bezieht sich auf eine Prüfeinrichtung für Bauelemente mittels Elektronen- oder Ionenstrahlen in einer Vakuumkammer. Durch die Abdichtung jedes einzelnen Signalstiftes entstehen Abdichtungsprobleme. Zur Vermeidung dieser Abdichtungsprobleme sieht die Erfindung vor, daß zur Durchführung der Signale in die Vakuumkammer 12 eine mehrlagige Leiterplatte 19 verwendet wird.

FIG 2

EP 0 492 217 A2

Die Erfindung betrifft eine Prüfeinrichtung für Bauelemente mittels gebündelter Elektronen- oder Ionenstrahlen in einer Vakuumkammer, die über eine Abdeckung zugänglich ist.

Bei manchen Testgeräten für elektronische Bauteile, wie z.B. dem Elektronenstrahlmeßgerät, müssen bis zu mehreren hundert elektrischer Signale zur Ansteuerung des Prüflings in eine evakuierte Kammer geleitet werden. Die Durchführungen der Leitungen müssen dazu abgedichtet sein. Zudem besteht durch die vielen erforderlichen Steckverbindungen im Signalweg die Gefahr von Kontaktfehlern.

Aufgabe der vorliegenden Erfindung ist es, Mittel anzugeben, durch die die durch die vakuumdichte Durchführung von Leitungen in einer Vakuumkammer auftretenden Probleme reduziert werden.

Zur Lösung dieser Aufgabe wird die Prüfeinrichtung gemäß der Erfindung derart ausgebildet, daß zur Durchführung der Signale in die Vakuumkammer eine mehrlagige Leiterplatte verwendet wird, deren obere und untere Lagen glatt ausgeführt sind, die an den Durchdringungsstellen zur Vakuumkammer mit Dichtungen abgedichtet sind.

In weiterer Ausgestaltung kann die Prüfeinrichtung auch so ausgebildet sein, daß am außerhalb der Vakuumkammer liegenden Teil der Leiterplatte Anschlußkontakte zur Zuführung der Signal- und Potentialspannungen für die Prüfung des Bauelements vorgesehen sind, und daß im innerhalb der Vakuumkammer liegenden Teil der Leiterplatte mindestens ein Nadeladapter angeordnet ist, der den Kontakt mit den von außen zugeführten Signal- und Potentialspannungen zu einem Hilfsadapter, der ebenfalls als Leiterplatte ausgebildet ist, herstellt, auf den das Bauelement kontaktiert ist.

Durch diese Maßnahmen werden die Abdichtungsprobleme erheblich reduziert, da nunmehr nicht jeder Signalstift der Steckverbindungen einzeln abgedichtet werden muß. Außerdem spart man durch diesen Aufbau gleichzeitig zwei Steckkontakte je Signalweg gegenüber einem herkömmlichen Aufbau.

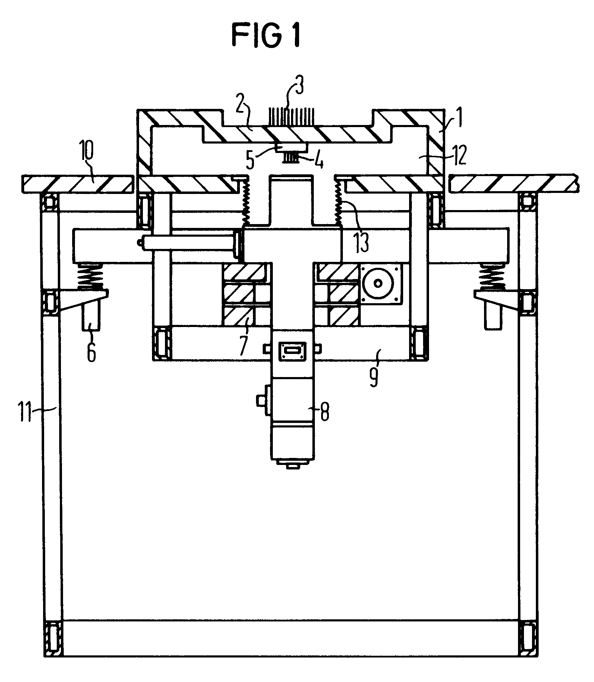

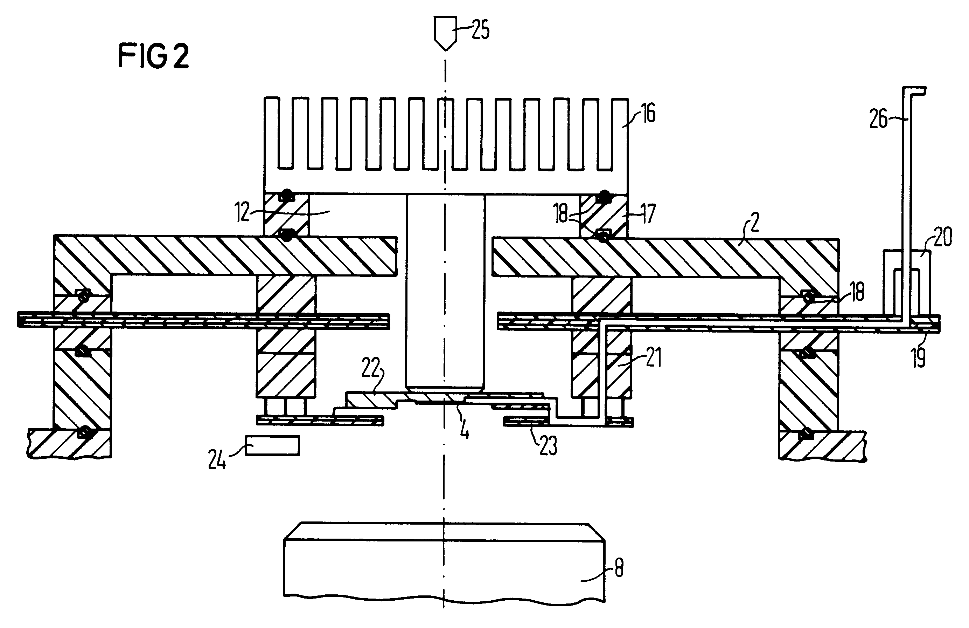

Anhand der FIG 1 sowie dem Ausführungsbeispiel nach FIG 2 wird die Erfindung näher erläutert.

Es zeigen

FIG 1 ein bekanntes Elektronenstrahlmeßgerät,

FIG 2 ein Elektronenstrahlmeßgerät nach der Erfindung.

In dem Prospekt der Firma Schlumberger "Technologie IDS 4000 Integrated Diagnostic System" wird ein Elektronenstrahlmeßgerät beschrieben mit dem es möglich ist, Fehler bei integrierten Schaltungen oder Leiterplatten rasch und präzise festzustellen. Sein grundsätzlicher Aufbau ist in FIG 1 dargestellt. Die den Elektronenstrahl erzeugende senkrecht angeordnete optoelektronische Säule 8 wird an einem Aufnahmerahmen 9 gehalten, der zugleich eine Justieranlage 7 enthält, die eine Verschiebung der Säule 8 in der horizontalen XY-Ebene gestattet. Die gesamte Apparatur befindet sich in einem Schrank, der Teil eines Arbeitsplatzes ist, der mit einer Arbeitsplatte 10 abgedeckt ist. Der Prüfling 4 (Bauelement) befindet sich im Inneren einer Vakuumkammer 12, die über die Abdeckhaube 2, die aus der Arbeitsplatte 10 herausragt, zugänglich ist. An der Innenseite der Abdeckhaube 2 ist eine Fassung 5 zur Aufnahme des Prüflings 4 angebracht und die einzelnen Kontakte dieser Fassung sind vakuumdicht auf die Außenseite der Abdeckhaube 2 in Anschlußstifte 3 geführt. Die optoelektronische Säule ragt mittels eines Balges 13 abgedichtet in die Vakuumkammer 12 hinein. Bei dieser Anordnung muß jeder einzelne Signalstift einzeln abgedichtet werden, was zu erheblichen Abdichtungsproblemen führen kann.

In FIG 2 ist das Elektronenstrahlmeßgerät nach FIG 1 skizzenhaft dargestellt. Anstelle der Leitungszuführung an der Oberseite der Abdeckhaube 2 ist die mehrlagige Leiterplatte 19 vorgesehen, die seitlich in die Haube eingeführt und an den Einführungsstellen fest verklebt ist. Die Abdichtung zur Haube hin erfolgt über Dichtringe 18. In dem Teil der Leiterplatte 19, der außerhalb der Vakuumkammer liegt, sind Anschlußkontakte 20 vorgesehen, über die die Signal- und Potentialleitungen in das Innere der Vakuumkammer 12 geleitet werden. Im inneren Teil der Leiterplatte ist ein Nadeladapter 21 angebracht, der die Verbindung zwischen der Leiterplatte 19 und einem weiteren Hilfsadapter 23 herstellt, der ebenfalls als Leiterplatte ausgebildet ist. Es handelt sich hierbei um einen Verschleißadapter, auf den das zu prüfende Bauelement 4 kontaktiert ist. Unterhalb des Bauelements ist wiederum die verstellbar angeordnete optoelektronische Säule 8 angeordnet. Oberhalb des Bauelements 4 befindet sich außerdem eine Kühlvorrichtung, die aus einem Kühlstempel 14 und aus einem mit Kühlrippen versehenen Kühlkörper 16 besteht, mit dem der Kühlstempel wärmekontaktmäßig verbunden ist. Die Abdichtung zur Kammer erfolgt über einen elektrisch isolierenden Ring 17 sowie den Dichtungen 18.

Der Signal- und Potentialzuführungsweg ist mit 26 bezeichnet. Die Kontaktierung des Hilfsadapters 23 mit dem Nadeladapter 21, der aus einem hochpoligen Federkontaktsatz besteht, erfolgt über die schematisch dargestellte Andruckmechanik 24. Die Wärmeabführung an den Kühlrippen 16 erfolgt über die auf die Kühlrippen 16 aufblasende geregelte Kühlluft 25.

**Patentansprüche**

1. Prüfeinrichtung für Bauelemente mittels gebündelter Elektronen oder Ionenstrahlen in einer Vakuumkammer, die über eine Abdeckung zugänglich ist, **dadurch gekennzeichnet,** daß zur Durchführung der Signale in die Vakuumkammer (12) eine mehrlagige Leiterplatte (19) verwendet wird, deren obere und untere Lagen glatt ausgeführt sind, und die an den Durchdringungsstellen zur Vakuumkammer (12) mit Dichtungen (18) abgedichtet sind.

2. Prüfeinrichtung nach Anspruch 1, **dadurch gekennzeichnet,** daß am außerhalb der Vakuumkammer (12) liegenden Teil der Leiterplatte (19) Anschlußkontakte (20) zur Zuführung der Signal- und Potentialspannungen für die Prüfung des Bauelements (4) vorgesehen sind, und daß im innerhalb der Vakuumkammer (12) liegenden Teil der Leiterplatte (19) mindestens ein Nadeladapter (21) angeordnet ist, der den Kontakt mit den von außen zugeführten Signal- und Potentialspannungen zu einem Hilfsadapter (23), der ebenfalls als Leiterplatte ausgebildet ist, herstellt, auf den das Bauelement (4) kontaktiert ist.

# FIG 1

FIG 2